# EUROPÄISCHE PATENTSCHRIFT

(11) **EP 2 615 621 B1**
(45) Veröffentlichungstag und Bekanntmachung des Hinweises auf die Patenterteilung: **17.06.2020**
(21) Anmeldenummer: 12179411.9
(22) Anmeldetag: 06.08.2012
(51) Int. Cl.: H01J 40/02, H01J 40/16, H01J 43/28, H01J 43/02

(54) **Detektorvorrichtung**
Detector device
Dispositif de détection

(30) Priorität: 16.08.2011 DE 102011052738; 29.02.2012 DE 102012101675
(43) Veröffentlichungstag der Anmeldung: 17.07.2013
(73) Patentinhaber: Leica Microsystems CMS GmbH, 35578 Wetzlar (DE)
(72) Erfinder: Widzgowski, Bernd, 69221 Dossenheim (DE); Schreiber, Frank, 72574 Bad Urach (DE); Birk, Holger, 74909 Meckesheim (DE)
(74) Vertreter: Hoffmann, Jürgen

(56) Entgegenhaltungen:
- EP-A1- 0 595 468
- EP-A1- 1 541 979
- US-A- 3 139 733
- US-A1- 2004 135 071
- US-A1- 2006 140 462
- Motohiro Suyama ET AL: "PHOTOMULTIPLIERS: Hybrid detector combines PMT and semiconductor-diode technologies", Laser Focus World, 1 March 2008 (2008-03-01), pages 1-8, XP55565747, Retrieved from the Internet: URL:https://www.laserfocusworld.com/articl es/2008/03/photomultipliers-hybrid-detecto r-combines-pmt-and-semiconductor-diode-tec hnologies.html [retrieved on 2019-03-07]

## Beschreibung

Die Erfindung betrifft ein Scanmikroskop aufweisend eine Detektorvorrichtung, die dazu ausgebildet ist Licht zu empfangen und elektrische Signale zu erzeugen, mit einem Lichtsensor, der eine Lichteinfallsseite aufweist, und mit einem Kühlbauteil.

US 2006/0140462 A1 offenbart ein Scanmikroskop aus dem Stand der Technik. Detektorvorrichtungen der eingangs genannten Art weisen oft einen temperaturabhängigen Dunkelstrom auf, der Rauschen verursacht. Durch Kühlen kann dieser Dunkelstrom verringert werden.

Aus DE 10 2009 036 066 A1 ist ein optoelektronischer Detektor bekannt, der eine mit dem Detektor wärmeleitend verbundene Kühlvorrichtung, nämlich ein Peltier-Element, aufweist. Zur Vermeidung des Entstehens von Tauwasser auf einer Oberfläche des optoelektronischen Detektors, ist ein Sensor zur Ermittlung eines momentanen Werts bezüglich der Umgebungsluftfeuchte und der Umgebungstaupunkttemperatur vorgesehen. Der Sensor ist mit einer Steuereinheit verbunden, welche die Kühlvorrichtung in Abhängigkeit des Werts steuert. Dieser optoelektronische Detektor hat den Vorteil, dass auf eine Kühlung nicht gänzlich verzichtet ist. Er hat jedoch den Nachteil, das die tatsächliche Kühlleistung auf ein geringes Maß begrenzt ist; nämlich auf das Maß, bei dem kein Tauwasser entsteht. Dies hat im Ergebnis zur Folge, dass ein Detektorrauschen nur unzureichend vermieden ist.

In derselben Druckschrift wird eine andere Detektorvorrichtung erwähnt, bei der Detektor samt der Kühlvorrichtung, typischerweise einem Peltier-Element, in einem luftdichten Gehäuse verkapselt ist, das mit einem getrockneten Gas gefüllt oder evakuiert ist. Die Abwärme der Kühlvorrichtung kann bei dieser Vorrichtung einem Kühlkörper zugeführt werden, der mit der Kühlvorrichtung wärmeleitend verbunden ist und/oder zum Beheizen anderer Bauteile, beispielsweise einem Eintrittsfenster des Gehäuses, verwendet werden. Diese Detektorvorrichtung wird jedoch als nachteilig ausgewiesen, weil die luftdichte Verkapselung aufwendig ist.

Tatsächlich hat sich in der Praxis sogar gezeigt, dass diese Detektorvorrichtung noch weitere Nachteile hat. Insbesondere ist das Kühlen oft nicht sehr effektiv. Darüber hinaus gestaltet sich das Kühlen als besonders schwierig, wenn sich der Detektor auf einem anderen elektrischen Potentialniveau befinden muss, als das Gehäuse. In diesem Fall kann das Peltier-Element nicht einfach zwischen Gehäuse und Detektor angeordnet werden. Eine solche Potentialdifferenz ist zumeist dann notwendig, wenn innerhalb des Detektors eine Beschleunigung von Photoelektronen erfolgen soll.

Beispielsweise aus US 5,508,740, US 5,596,228 oder US 4,833,889 sind Detektorvorrichtungen bekannt, bei denen jeweils auf der einer Lichteinfallseite eines Lichtsensors abgewandten Seite eine aktive Kühlvorrichtung vorgesehen ist. Diese Detektorvorrichtungen haben den Nachteil, dass ein Großteil der Kühlleistung ungenutzt verloren geht.

Es ist die Aufgabe der vorliegenden Erfindung, ein Scanmikroskop aufweisend eine Detektorvorrichtung anzugeben, die ein effizienteres Kühlen, insbesondere auch bei Verwendung von Detektoren, die auf einem anderen elektrischen Potentialniveau liegen, als das Gehäuse, ermöglicht.

Die Aufgabe wird durch eine Detektorvorrichtung gemäß Anspruch 1 gelöst.

Insbesondere für eine Ausführungen, bei denen der Lichtsensor und/oder ein den Lichtsensor aufweisender Detektor mit einer gefährlichen Spannung betrieben wird, aber auch zum Schutz des Lichtsensors und/oder der nachgeschalteten Elektronik kann vorteilhaft vorgesehen sein, dass die Detektorvorrichtung ein Gehäuse aufweist und/oder dass der Lichtsensor und das Kühlbauteil in einem Gehäuse angeordnet sind.

Bei einer ganz besonders vorteilhaften Ausführungsform ist, insbesondere innerhalb eines Gehäuses, ein weiteres Kühlbauteil vorgesehen. Insbesondere kann vorteilhaft ein weiteres Kühlbauteil vorgesehen sein, das mit dem Kühlbauteil in Wärme leitendem Kontakt steht.

Eine besonders effektive Kühlung kann vorteilhaft dadurch erreicht werden, dass ein Lichtweg für das zu detektierende Licht festgelegt ist, der durch das Kühlbauteil und/oder das weitere Kühlbauteil hindurch verläuft. Insbesondere kann vorgesehen sein, dass das Kühlbauteil und/oder das weitere Kühlbauteil die für das zu detektierende Licht erreichbare Sensorfläche - beispielsweise kreisförmig - umgibt.

Beispielsweise kann vorgesehen sein, dass das Kühlbauteil und/oder dass weitere Kühlbauteil einen Durchgang, insbesondere eine Durchgangsbohrung, aufweist, durch die hindurch das zu detektierende Licht zu dem Lichtsensor gelangt. Hierbei kann insbesondere vorgesehen sein, dass der Durchbruch konisch und/oder mit schrägen Wandungen ausgeführt ist, um zu ermöglichen, dass auch schräg zur Oberfläche des Lichtsensors einfallendes Licht ungehindert durch das Kühlbauteil und/oder das weitere Kühlbauteil hindurch zu dem Lichtsensor gelangen kann.

Es jedoch auch vorgesehen sein, dass das Kühlbauteil und/oder das weitere Kühlbauteil zwei- oder mehrteilig aufgebaut ist, wobei die Teile derart zueinander angeordnet sind, dass ein Zwischenraum verbleibt, durch den hindurch der Lichtweg für das detektierende Licht verläuft.

Auch das weitere Kühlbauteil kann vorteilhaft als wärmeleitendes, elektrisch isolierendes Zwischenelement ausgebildet sein. Insbesondere kann, was im Detail im Folgenden noch beschrieben wird, das weitere Kühlbauteil als passives Kühlbauteil, insbesondere als wärmeableitender Ring, ausgebildet sein, der zwischen dem Detektor und einem aktiven Kühlbauteil, bspw. einen Peltier-Element, angeordnet ist.

Bei einer besonderen Ausführung ist das Kühlbauteil als wärmeleitendes, elektrisch isolierendes Zwischenelement ausgebildet. Eine solche Ausführung hat den besonderen Vorteil, dass die Wärme auch dann von dem Lichtsensor weg geleitet werden kann, wenn dieser - beispielsweise gegenüber einem umgebenden Gehäuse - auf einem anderen Spannungsniveau, insbesondere auf einem Spannungsniveau von über 1000 V, insbesondere von über 2000 V, insbesondere von über 4000 V, insbesondere von ca. 8000 V, liegt. Insbesondere kann ein solches Wärmeleitung des, elektrisch isolieren das Zwischenelement beispielsweise als passives Kühlbauteil, durch das hindurch eine Wärmeleitung stattfindet, ausgebildet sein.

Auch das weitere Kühlbauteil kann bei einer vorteilhaften Ausführung derart angeordnet sein, dass es in unmittelbarem Kontakt zu einem Lichtsensor des Detektors, bspw. einer Photokatode, steht. Es kann - alternativ oder zusätzlich - auch vorgesehen sein, dass das weitere Kühlbauteil in unmittelbarem Kontakt zu einem Substrat steht, das einen Lichtsensor, bspw. eine Photokatode, trägt.

Durch den unmittelbaren Kontakt des Kühlbauteils und/oder des weiteren Kühlbauteils zu einem Lichtsensor des Detektors und/oder zu einem Substrat, das einen Lichtsensor trägt, wird eine besonders effektive Kühlung erreicht. Insbesondere hat eine solche Ausführung den Vorteil, dass lediglich die Bauteile gekühlt werden, die tatsächlich ein temparaturabhängiges Rauschverhalten zeigen.

Darüber hinaus ist bei einer solchen Ausführung vorteilhafter Weise eine wesentlich geringere Kühlleistung erforderlich, was insbesondere von Vorteil ist, wenn das Kühlbauteil und/oder das weitere Kühlbauteil als aktives Kühlbauteil, bspw. als Peltier-Element, ausgebildet ist. In dem Fall, dass das Kühlbauteil und/oder das weitere Kühlbauteil als aktives Kühlbauteil ausgebildet ist, fällt in vorteilhafter Weise daher auch weniger Abwärme an, die nach außen transportiert werden muss.

Bei einer besonderen Ausführung ist vorgesehen, dass der Lichtsensor und das Gehäuse mittels des Kühlbauteils und/oder des weiteren Kühlbauteils wärmeleitend verbunden sind, wobei die Kontaktfläche des Kühlbauteils und/oder des weiteren Kühlbauteils mit dem Lichtsensor kleiner ist, als die Kontaktfläche des Kühlbauteils und/oder des weiteren Kühlbauteils mit dem Gehäuse. Eine solche Ausführung hat den ganz besonderen Vorteil, dass einerseits ein besonders guter Wärme Abtransport von dem Lichtsensor weg gewährleistet ist, während andererseits die freie Zugänglichkeit der lichtempfindlichen Oberfläche des Lichtsensors für das zu detektierende Licht allenfalls geringfügig eingeschränkt ist.

Wie bereits erwähnt, können das Kühlbauteil und/oder das weitere Kühlbauteil vorteilhaft als aktives Kühlbauteil, insbesondere als Peltier-Element oder als Wärmepumpe oder als Heat-Pipe ausgebildet sein. Bei einer ganz besonders vorteilhaften Ausführung ist das Kühlbauteil als ringförmiges Peltier-Element ausgebildet. Eine solche Ausführung bietet den Vorteil, dass durch die Ringmitte der Lichtweg für das zu detektierende Licht verlaufen kann, so dass der Lichtweg beim Durchtritt durch das ringförmige Peltier-Element im Wesentlichen koaxial zur Rotationssymmetrieachse des ringförmigen Peltier-Elements angeordnet ist.

Bei einer ganz besonders vorteilhaften Ausführung sind das Kühlbauteil und/oder das weitere Kühlbauteil derart angeordnet, dass die Abwärme des Kühlbauteils und/oder des weiteren Kühlbauteils wenigstens ein Eintrittsfenster des Gehäuses und/oder eine Eintrittsoptik des Gehäuses erwärmt. Eine solche Ausführung hat den ganz besonderen Vorteil, dass sich auf den Oberflächen des Eintrittsfensters bzw. auf den Oberflächen der Eintrittsoptik, bspw. eine Linse oder eine Anordnung mehrerer Linsen, kein Tauwasser absetzt. Dies ist insbesondere dann gewährleistet, wenn unter Ausnutzung der Abwärme die Temperatur der Oberflächen des Eintrittsfensters bzw. der Optik oberhalb des Taupunktes gehalten wird.

In besonders vorteilhafter Weise kann vorgesehen sein, dass das Kühlbauteil und/oder das weitere Kühlbauteil als passives Kühlbauteil ausgebildet ist, durch das hindurch ein Wärmestrom stattfindet. Von besonderem Vorteil ist es, wenn das passive Kühlbauteil und/oder das weitere passive Kühlbauteil eine gute Wärmeleitfähigkeit aufweist, um einen schnellen Wärmetransport zu gewährleisten.

Insoweit kann vorteilhaft vorgesehen sein, dass das Kühlbauteil und/oder das weitere Kühlbauteil eine Wärmeleitfähigkeit größer 1 W/mK, insbesondere größer 10 W/mK, insbesondere größer 100 W/mK, ganz insbesondere größer 500 W/mK aufweist.

Bei einer ganz besonders vorteilhaften Ausführung ist das passive Kühlbauteil und/oder das weitere passive Kühlbauteil derart geformt und dimensioniert, dass es sich passgenau und möglichst großflächig an das zu kühlende Bauteil der Detektorvorrichtung, insbesondere an einen Lichtsensor und/oder an ein lichtsensortragendes Substrat, anschmiegen kann. Hierdurch ist eine besonders gute Kühlung erreichbar. Gleiches gilt in analoger Weise auch für den Fall, dass das Kühlbauteil als aktives Kühlbauteil ausgebildet ist und/oder das das weitere Kühlbauteil als aktives weiteres Kühlbauteil ausgebildet ist. Die Ausformung des Kühlbauteils bzw. des weiteren Kühlbauteils erfolgt jedoch vorzugsweise stets derart, dass die Funktion des Detektors und/oder die Funktion von Teilen des Detektors nicht nachteilig, bspw. durch Abschattung eines Lichtweges, beeinträchtigt wird.

Bei einer ganz besonders vorteilhaften Ausführung, die insbesondere dann einsetzbar ist, wenn der Detektor und/oder Teile des Detektors auf einem anderen elektrischen Potentialniveau liegen, als das Gehäuse, ist das Kühlbauteil und/oder das weitere Kühlbauteil elektrisch weitgehend isolierend ausgebildet. Insbesondere kann vorgesehen sein, dass das Kühlbauteil und/oder das weitere Kühlbauteil eine elektrische Leitfähigkeit kleiner als 10⁻⁷ S/m, insbesondere kleiner als 10⁻⁸ S/m aufweist.

Eine solche Ausführung hat den ganz besonderen Vorteil, dass der Detektor über das Kühlbauteil bzw. das weitere Kühlbauteil in mechanischem Kontakt zum Gehäuse stehen kann, während der Detektor dennoch elektrisch zumindest soweit isoliert ist, dass er auf dem erforderlichen Potentialniveau betrieben werden kann. Beispielsweise kann vorgesehen sein, dass der Detektor eine Beschleunigungsvorrichtung zum Beschleunigen von mittels einer Photokatode erzeugter Elektronen aufweist, wobei die beschleunigten Elektronen bspw. einer Avalanchediode zugeleitet werden können. Es kann alternativ auch vorgesehen sein, dass der Detektor einen Sekundärelektronenvervielfacher beinhaltet. Insoweit kann es vorkommen, dass zwischen dem Detektor oder Teilen des Detektors und dem Gehäuse eine elektrische Spannungsdifferenz von mehreren 1000 Volt anliegen muss.

Insbesondere um solchen Spannungsdifferenzen standhalten zu können, ist bei einer besonderen Ausführungsform des Detektors vorgesehen, dass das Kühlbauteil und/oder das weitere Kühlbauteil zumindest teilweise aus einem elektrisch isolierenden und thermisch leitenden Material, insbesondere aus Bornitrid, Aluminiumnitrid, Aluminiumoxid, Diamant, synthetischem Diamant oder einer Kombination aus diesen Materialien besteht. Diese Stoffe zeichnen sich einerseits durch eine hohe Wärmeleitfähigkeit und andererseits durch eine sehr geringe elektrische Leitfähigkeit aus. Darüber hinaus bieten diese Materialien den Vorteil, dass sie, bspw. durch Schleifen, Drehen oder Fräsen, einfach und genau bearbeitbar sind.

Wie bereits erläutert kann vorteilhaft vorgesehen sein, dass das Kühlbauteil und/oder das weitere Kühlbauteil sowohl ein elektrischer Isolator, als auch ein thermischer Leiter ist. Insbesondere um dies zu erreichen, können das Kühlbauteil und/oder dass weitere Kühlbauteil zumindest teilweise aus einem Kompositmaterial bestehen. Beispielsweise können das Kühlbauteil und/oder dass weitere Kühlbauteil jeweils einen Kern aus einem thermisch leitenden Material, beispielsweise aus einem Metall, wie beispielsweise Aluminium oder Kupfer, aufweisen, der wenigstens teilweise von einem elektrischen Isolator umgeben ist. Insbesondere kann vorgesehen sein, dass der umgebende elektrische Isolator - bezogen auf die Wärme Leitungsrichtung - dünner ist, als der Kern. Insbesondere kann der Kern eine Dicke von mehreren Millimetern oder gar mehreren Zentimetern aufweisen.

Als Kompositbauteil können das Kühlbauteile und/oder das weitere Kühlbauteil, insbesondere aufgrund der leichten Bearbeitbarkeit eines beispielsweise metallischen Kerns, ohne größeren Aufwand auch in außergewöhnlichen Formen hergestellt werden.

Einerseits fungiert der Kern als Abstandhalter beispielsweise zwischen dem Lichtsensor und einem Gehäuse oder beispielsweise zwischen dem Lichtsensor und einem, insbesondere als Peltierelement ausgeführten, Kühlbauteil und/oder weiteren Kühlbauteil. Darüber hinaus wird die Eigenschaft der guten Wärmeleitfähigkeit des Blocks ausgenutzt. Zur Herbeiführung einer elektrischen Isolation ist der Block von einem elektrischen Isolator umgeben. Bei einer besonderen Ausführung ist der elektrische Isolator als Isolatorfolie, insbesondere als Kunststofffolie ausgeführt. Beispielsweise bietet sich die Verwendung einer Kaptonfolie an. Da eine geeignete Kunststofffolie, beispielsweise eine Kartonfolie, bereits bei einer Dicke von Bruchteilen eines Millimeters eine sehr hohe elektrische Durchschlagfestigkeit aufweisen kann, kann die elektrische Isolatorfolie wesentlich dünner ausgebildet sein, als der Kern. Hierdurch wird insbesondere erreicht, dass die elektrische Isolatorfolie kaum thermisch isolierend wirkt. Die besondere Kombination des wärmeleitenden Kerns mit der dünneren elektrischen Isolationsfolie führt zu einem Kühlbauteil und/oder weiteren Kühlbauteil, dass sowohl elektrisch isolierend, als auch thermisch leitend ist.

Der umgebende elektrische Isolator kann auch aus einem zunächst flüssigen Material bestehen, das beispielsweise durch Streichen, Aufspritzen oder Tauchen auf den Kern aufgebracht wird und dort aushärtet.

Insbesondere für Ausführungsformen, bei denen hohe Potentialdifferenzen vorliegen kann - nach einem unabhängigen Erfindungsgedanken, der auch losgelöst von einer speziellen Anordnung des Kühlbauteils und/oder des weiteren Kühlbauteils umsetzbar ist - vorteilhaft vorgesehen sein, dass das Kühlbauteil und/oder das weitere Kühlbauteil zur Erhöhung der Kriechstromfestigkeit an einer Außenfläche einen mittels eines Labyrinths und/oder mittels Rippen und/oder mittels wenigstens eine Not und/oder mittels wenigstens einem Vorsprung verlängerten Kriechweg aufweist.

Bei einer ganz besonderen Ausführungsform ist vorgesehen, dass das Kühlbauteil und/oder das weitere Kühlbauteil, insbesondere zur Erhöhung der Kriechstromfestigkeit, wenigstens einen umlaufenden Vorsprung oder wenigstens eine umlaufende Nut aufweist. Eine solche Ausführung hat den besonderen Vorteil, dass der Kriechweg entlang der Oberfläche des Kühlbauteils bzw. des weiteren Kühlbauteils verlängert wird, so dass die Gefahr eines elektrischen Überschlags zumindest vermindert ist.

Insbesondere für Ausführungsformen, bei denen hohe Potentialdifferenzen vorliegen kann - nach einem unabhängigen Erfindungsgedanken, der auch losgelöst von einer speziellen Anordnung des Kühlbauteils und/oder des weiteren Kühlbauteils umsetzbar ist - vorteilhaft vorgesehen sein, dass Zwischenräume des Kühlbauteils und/oder des weiteren Kühlbauteils mit einem elektrisch isolierenden Material gefüllt sind. Insbesondere bei der Verwendung eines thermoelektrischen Wandlers, insbesondere eines Peltierelements, kann zusätzlich vorteilhaft vorgesehen sein, dass das Füllmaterial sowohl elektrisch, als auch thermisch isolierend ausgebildet ist. Bei einer besonderen Ausführung ist das Kühlbauteil und/oder das weitere Kühlbauteil als thermoelektrischer Wandler, insbesondere als Peltierelement ausgebildet, dessen Zwischenräume mit Epoxidharz oder Silikon gefüllt, insbesondere ausgegossen, sind.

Durch das Füllen der Zwischenräume des Kühlbauteils und/oder des weiteren Kühlbauteils mit einem elektrisch isolierenden Material können ungewollte Spannungsüberschläge wirkungsvoll vermieden werden. Durch das Füllen mit elektrisch isolierenden Material ist ein Überschlagen von Funken entlang der Oberfläche von inneren Bauteilen, wie beispielsweise der zumeist säulenförmigen Halbleiterelemente eines Peltierelements, wirkungsvoll unterbunden.

In vorteilhafter Weise können das Kühlbauteil und/oder das weitere Kühlbauteil im Wesentlichen ringförmig oder zylinderförmig ausgebildet sein. Wie bereits erwähnt, bietet dies sowohl besondere Vorteile im Hinblick darauf, das Kühlbauteil bzw. das weitere Kühlbauteil für eine effektive Kühlung günstig, bspw. in Kontakt zu einem Lichtsensor oder einem einen lichtsensortragenden Substrat, zu bringen und andererseits den weiteren Vorteil, dass ein Durchbruch für den Lichtweg des zu detektierenden Lichts besteht.

Bei einer besonders effektiv und zuverlässig arbeitenden Ausführungsform sind das Kühlbauteil und das weitere Kühlbauteil thermisch in Reihe geschaltet. Insbesondere kann ganz besonders vorteilhaft vorgesehen sein, dass das Kühlbauteil als passives Kühlbauteil, bspw. als Bornitridring, ausgebildet ist und in unmittelbarem Kontakt zu einem Lichtsensor und/oder zu einem lichtsensortragenden Substrat steht.

Darüber hinaus kann vorteilhaft vorgesehen sein, dass dieses Kühlbauteil mit einem weiteren Kühlbauteil thermisch in Kontakt steht, das als aktives Kühlbauteil, bspw. als ringförmiges Peltier-Element ausgebildet ist.

Vorzugsweise sind das ringförmige Kühlbauteil und das ringförmige weitere Kühlbauteil koaxial zueinander angeordnet, wobei der Lichtweg für das zu detektierende Licht entlang der Rotationssymmetrieachse des Kühlbauteils und des weiteren Kühlbauteils verläuft. Darüber hinaus kann in vorteilhafter Weise vorgesehen sein, dass das weitere, aktive Kühlbauteil, bspw. die heiße Seite eines Peltier-Elements, in Kontakt zu einem Eintrittsfenster oder einer Eintrittsoptik des Gehäuses steht. Eine solche Anordnung zeichnet sich dadurch aus, dass ein Lichtsensor des Detektors besonders effektiv gekühlt werden kann, weil ein direkter Wärmetransport von dem Lichtsensor bzw. seinem Substrat über das passive Kühlbauteil zu dem aktiven Kühlbauteil erfolgt. Darüber hinaus wird in vorteilhafter Weise die Abwärme des aktiven Kühlbauteils zur Vermeidung des Entstehens von Tauwasser auf dem Eintrittsfenster bzw. der Eintrittsoptik verwendet. Wenn bei dieser Anordnung als Kühlbauteil ein elektrisch weitgehend isolierendes Material eingesetzt wird, bspw. Bornitrid, so ist es in sehr vorteilhafter Weise ermöglicht, den Detektor auf einem Potentialniveau zu betreiben, das sich vom Potentialniveau des Gehäuses unterscheidet.

Insbesondere zur Vermeidung des Entstehens von Tauwasser kann vorteilhaft vorgesehen sein, dass das Gehäuse gasdicht ist und/oder das in dem Gehäuse ein Vakuum vorliegt. Bspw. kann auch vorgesehen sein, dass das gasdichte Gehäuse mit einem Gas, vorzugsweise einem getrockneten Gas, gefüllt wird, dessen Taupunkt besonders niedrig liegt. Beispielsweise kann es vorteilhaft sein, ein Trocknungsmittel in das Gehäuse einzubringen. Dieses dient dazu, eventuell noch vorhandene Restfeuchte zu entfernen oder eindringende Feuchtigkeit zu absorbieren.

Bei einer besonders effizient kühlenden Ausführung ist das Kühlbauteil ein passives Kühlbauteil, das Wärme von dem Lichtsensor und/oder von dem Substrat des Lichtsensors zu einem weiteren, aktiven Kühlbauteil, insbesondere einem Peltier-Element, leitet, das nicht mit dem Lichtsensor und nicht mit einem Substrat des Lichtsensors in unmittelbarem Kontakt steht. Zusätzlich ist vorgesehen, dass das weitere, aktive Kühlbauteil Wärme an das Gehäuse abgibt. Durch die besondere Reihenfolge der Anordnung ist erreicht, dass die zusätzliche Prozesswärme des aktiven Kühlbauteils nicht durch das passive Kühlbauteil hindurch geleitet werden muss.

Ganz besonders vorteilhaft lässt sich die erfindungsgemäße Detektorvorrichtung mit oder in einem konfokalen Scanmikroskop, einsetzen. Bei einer ganz besonders vorteilhaften Ausführung eines konfokalen Scanmikroskopes weist dieses mehrere der erfindungsgemäßen Detektorvorrichtungen auf. Bspw. kann vorgesehen sein, dass den einzelnen Detektorvorrichtungen unterschiedliche Detektionsspektralbereiche zugeordnet sind und/oder zuordenbar sind.

Weitere Ziele, Vorteile, Merkmale und Anwendungsmöglichkeiten der vorliegenden Erfindung ergeben sich aus der nachfolgenden Beschreibung eines Ausführungsbeispieles anhand der Zeichnung.

Es zeigen:
Fig. 1 schematisch ein Ausführungsbeispiel einer erfindungsgemäßen Detektorvorrichtung,
Fig. 2 schematisch ein Ausführungsbeispiel einer anderen erfindungsgemäßen Detektorvorrichtung,
Fig. 3 schematisch ein Ausführungsbeispiel einer dritten erfindungsgemäßen Detektorvorrichtung und
Fig. 4 schematisch ein Ausführungsbeispiel einer vierten erfindungsgemäßen Detektorvorrichtung und
Fig. 5 eine Detaildarstellung eines weiteren Ausführungsbeispiels einer erfindungsgemäßen Detektorvorrichtung.

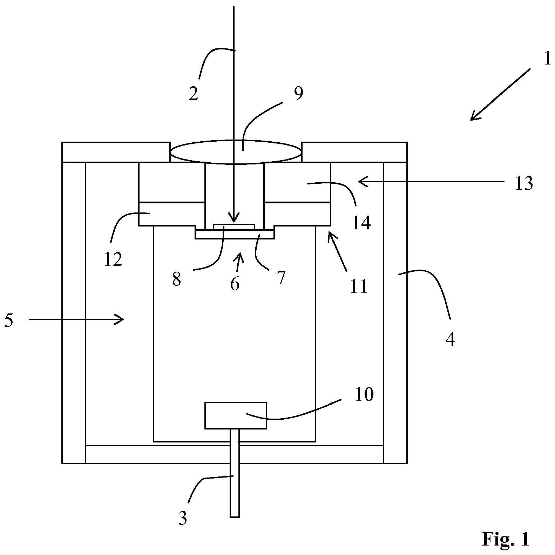

Figur 1 zeigt eine Detektorvorrichtung 1, die dazu ausgebildet ist, Licht 2 zu empfangen und an einem elektrischen Ausgang 3 elektrische Signale bereitzustellen. Die Detektorvorrichtung 1 weist ein Gehäuse 4 auf, in dem ein Detektor 5 angeordnet ist.

Der Detektor 5 weist einen Lichtsensor 6, nämlich eine auf einem Substrat 7 angeordnete Photokathode 8 auf, die in Transmissionsanordnung betrieben wird. Dies bedeutet, dass die Photokathode 8 auf ihrer einer Eintrittsoptik 9 des Gehäuses 4 zugewandten Seite das zu detektierende Licht 2 empfängt und auf der von dieser abgewandten Seite Fotoelektronen abgibt.

Die Photokathode 8 und ihr Substrat 7 liegen auf einem Potentialniveau von - 8000 V, während das Gehäuse 4 auf einem Potentialniveau von 0 V liegt.

Der Detektor 5 weist darüber hinaus eine Avalanchediode 10 auf, die auf einem Potentialniveau von - 400 V liegt. Die von der Photokathode 8 erzeugten Fotoelektronen werden auf Grund der zwischen der Photokathode 8 und der Avalanchediode10 bestehenden Potentialdifferenz beschleunigt und treffen auf eine Avalanchediode10, die elektrische Signale über den elektrischen Ausgang 3 ausgibt.

Die Detektorvorrichtung 1 weist innerhalb des Gehäuses 4 ein Kühlbauteil 11 auf, das als passives Kühlbauteil ausgebildet ist. Konkret ist das Kühlbauteil 11 als wärmeleitendes, elektrisch isolierendes Zwischenelement 12 ausgebildet. Das Zwischenelement 12 weist eine ringförmige Form auf, wobei die Mittelachse des Zwischenelements koaxial zum Lichtweg des zu detektierenden Lichts 2 verläuft.

Die Detektorvorrichtung 1 weist darüber hinaus innerhalb des Gehäuses 4 ein weiteres Kühlbauteil 13 auf, das als ringförmiges Peltier-Element 14 ausgebildet ist. Das ringförmige Peltier-Element 14 ist koaxial zu dem ringförmigen Zwischenelement 12 angeordnet.

Das ringförmige Peltier-Element 14 steht in wärmeleitendem Kontakt zu dem Zwischenelement 12. Das Zwischenelement 12 steht in wärmeleitendem Kontakt zum Substrat 7.

Über das wärmeleitende, elektrisch isolierende Zwischenelement 12 kann die Kühlleistung zur Kühlung des Substrats 7 und der Photokathode 8 besonders effektiv genutzt werden. Darüber hinaus ist vorgesehen, dass die warme Seite des ringförmigen Peltier-Elements 14 dem Gehäuse 4 und der Eintrittsoptik 9 zugewandt ist. Hierdurch wird die Eintrittsoptik 9 neu erwärmt, so dass sich kein Tauwasser niederschlagen kann. Der übrige Zwischenraum zwischen dem Detektor 5, dem Zwischenelement 12 und dem ringförmigen Peltier-Element 14 zu dem Gehäuse 4 ist mit einer thermisch und elektrisch isolierenden Vergussmasse gefüllt. Der Bereich zwischen der Eintrittsoptik 9 und der Photokathode 8 ist mit einem getrockneten Gas gefüllt.

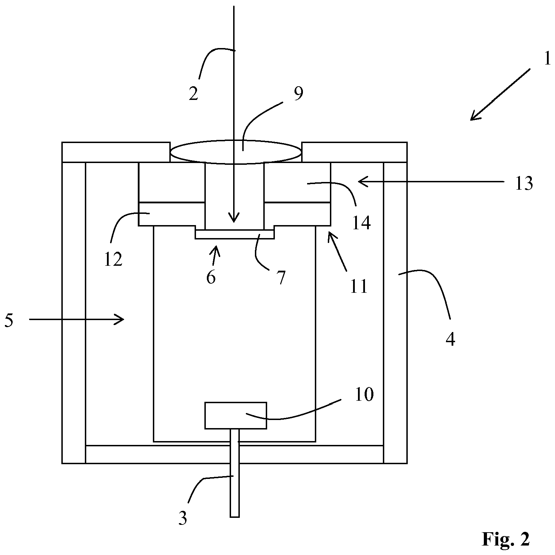

Figur 2 zeigt eine andere Detektorvorrichtung, bei der das Zwischenelement 12 in unmittelbarem, wärmeleitenden Kontakt zur Photokathode 8 steht.

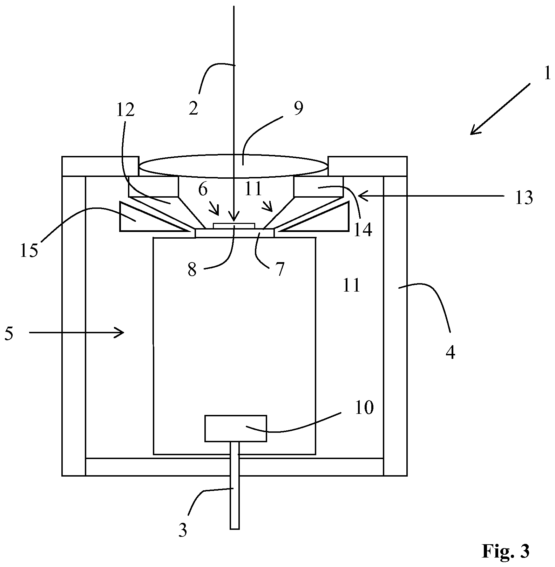

Figur 3 zeigt schematisch ein Ausführungsbeispiel einer dritten erfindungsgemäßen Detektorvorrichtung, die im Grundaufbau im Wesentlichen den Detektorvorrichtungen entspricht, die in den Figuren 1 und 2 gezeigt sind. Allerdings weist das Kühlbauteil 11, das als wärmeleitendes, elektrisch isolierende zwischen Element 12 ausgebildet ist, einen konischen Durchgang für das zu detektierende Licht 2 auf. Darüber hinaus ist das weitere Kühlbauteil 14 mit einem (gegenüber den Ausführungsformen, die in den Figuren 1 und 2 gezeigt sind) im Durchmesser vergrößerten Durchgang versehen. Außerdem ist ein vergrößertes Eintrittsfenster 9 des Gehäuses 4 eingebaut. Diese Ausführung hat den besonderen Vorteil, dass die numerische Apertur wesentlich vergrößert ist. Dadurch kann insbesondere auch schräg ein fallendes Licht ungehindert zu dem als Photokathode 8 ausgebildeten Lichtsensor gelangen.

Insbesondere ist das Eintrittsfenster wesentlich größer als der Lichtsensor, in diesem Beispiel die Photokathode 8, ausgeführt. Der Radius der freien Öffnung des Kühlbauteils 11 und des weiteren Kühlbauteils 13 nimmt daher von der Photokathode 8 ausgehend in Richtung zum Eintrittsfenster hin zu. Hierdurch wird zusätzlich erreicht, dass auch die Kontaktfläche zwischen dem als Zwischenelement 12 ausgeführten Kühlbauteil 11 und dem weiteren Kühlbauteil 14, nämlich dem Peltier-Element 14, wesentlich vergrößert ist, was insbesondere eine gute Wärmeableitung gewährleistet.

Bei der in Figur 3 dargestellten Ausführungsform ist außerdem die Kontaktfläche des Kühlbauteils 11 mit dem Substrat 7 des Lichtsensors 6 größer, als die Kontaktfläche des Kühlbauteils 11 mit dem weiteren Kühlbauteil 14, ohne dass das Kühlbauteil 11 unmittelbar in Kontakt mit weiteren Bauteilen des Detektors 5 steht. Insbesondere hierzu ist auch die Außenkontur des Kühlbauteils 11 konisch ausgebildet.

Zum bewirken einer zusätzlichen thermischen Isolation relativ zum Gehäuse ist ein ringförmiger thermischer Isolatoren 15 vorgesehen, der das Kühlbauteil 11 umgibt.

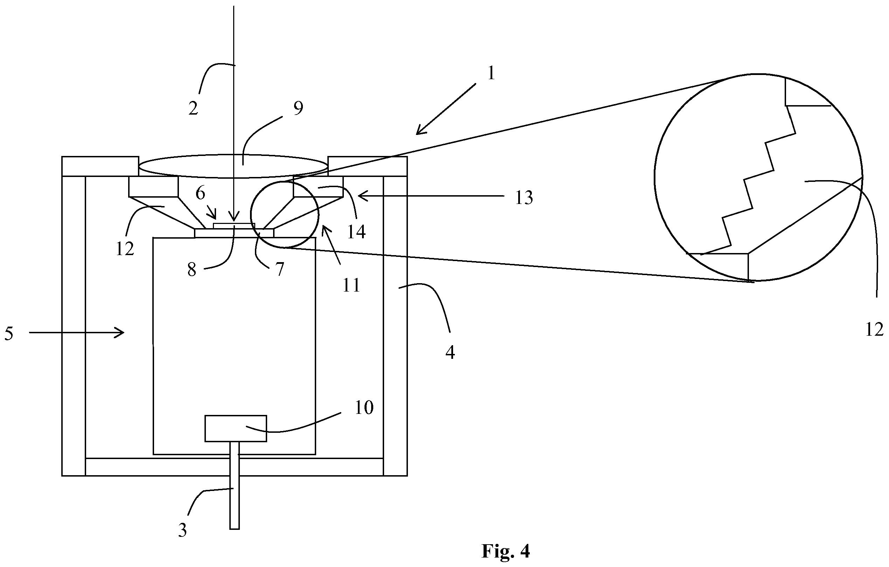

Figur 4 zeigt schematisch ein Ausführungsbeispiel einer vierten erfindungsgemäßen Detektorvorrichtung, die im Wesentlichen Aufbau der in Figur 3 gezeigten Ausführung entspricht. Zur Erhöhung der Kriechstromfestigkeit ist der Durchgang für das Licht 2 des Zwischenelements 12 mit umlaufenden Rippen 15 versehen. Hierdurch ist der Kriechweg von dem Lichtsensor 6 zu dem weiteren Kühlbauteil 13 vergrößert und dadurch die Gefahr eines elektrischen Überschlags wesentlich verringert.

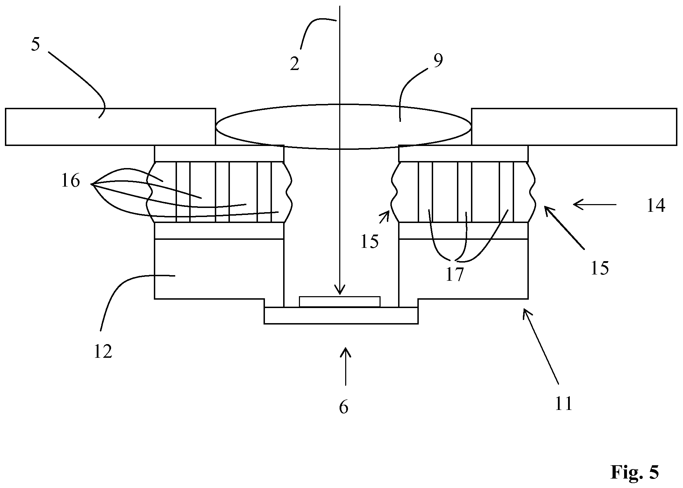

Figur 5 zeigt eine Detaildarstellung eines weiteren Ausführungsbeispiels einer erfindungsgemäßen Detektorvorrichtung
Bei dieser Ausführung sind die Zwischenräume des weiteren Kühlbauteils 13, nämlich des Peltier-Elements 14, mit einem elektrisch isolierenden Material 16, beispielsweise mit Silikon, gefüllt sind. Durch das Füllen der Zwischenräume mit einem elektrisch isolierenden Material 16 können ungewollte Spannungsüberschläge wirkungsvoll vermieden werden. Durch das Füllen mit elektrisch isolierenden Material 16 ist ein Überschlagen von Funken entlang der Oberfläche von inneren Bauteilen, wie den säulenförmigen Halbleiterelementen 17 des Peltier-Elements 14, wirkungsvoll unterbunden.

Zusätzlich ist das elektrisch isolierende Material 16 an der Außenseite und im Bereich des Durchganges für das Licht 2 mit Rippen 15 versehen, um den Kriechweg zu verlängern.

### Bezugszeichenliste

- 1: Detektorvorrichtung
- 2: zu detektierendes Licht
- 3: elektrischer Ausgang
- 4: Gehäuse
- 5: Detektor
- 6: Lichtsensor
- 7: Substrat
- 8: Photokathode
- 9: Eintrittsoptik
- 10: Avalanchediode
- 11: Kühlbauteil
- 12: Zwischenelement
- 13: Weiteres Kühlbauteil
- 14: Peltier-Element
- 15: Rippen
- 16: elektrisch isolierenden Material
- 17: Halbleiterelemente

## Patentansprüche

1. Scanmikroskop aufweisend eine Detektorvorrichtung (1), die dazu ausgebildet ist Licht (2) zu empfangen und elektrische Signale zu erzeugen, mit einem Lichtsensor (6), der eine Lichteinfallsseite aufweist, und mit einem Kühlbauteil, wobei das Kühlbauteil auf der Lichteinfallseite des Lichtsensors (6) in unmittelbarem Kontakt zu dem Lichtsensor und/oder zu einem den Lichtsensor (6) tragenden Substrat (7) steht, wobei die Detektorvorrichtung eine Avalanchediode (10) mit einem vorgeschalteten Elektronenbeschleuniger aufweist.

2. Scanmikroskop nach Anspruch 1, **dadurch gekennzeichnet, dass**
a. die Detektorvorrichtung ein Gehäuse (4) aufweist und/oder dass der Lichtsensor (6) und das Kühlbauteil (11) in einem Gehäuse (4) angeordnet sind und/oder dass
b. ein Lichtweg (2) für das zu detektierende Licht (2) festgelegt ist, der durch das Kühlbauteil (11) hindurch verläuft und/oder dass
c. das Kühlbauteil (11) als wärmeleitendes, elektrisch isolierendes Zwischenelement (12) ausgebildet ist und/oder dass
d. die Detektorvorrichtung ein Gehäuse (4) aufweist und dass das Gehäuse (4) gasdicht ist und/oder dass in dem Gehäuse (4) ein Vakuum vorliegt.

3. Scanmikroskop nach Anspruch 1 oder 2, **dadurch gekennzeichnet, dass**, insbesondere innerhalb des Gehäuses (4), ein weiteres Kühlbauteil (13) vorgesehen ist und/oder dass ein weiteres Kühlbauteil (13) vorgesehen ist, das mit dem Kühlbauteil (11) in wärmeleitendem Kontakt steht und/oder dass ein weiteres Kühlbauteil (13) vorgesehen ist, wobei das Kühlbauteil (11) und das weitere Kühlbauteil (13) thermisch in Reihe geschaltet sind.

4. Detektorvorrichtung (1) nach Anspruch 3, **dadurch gekennzeichnet, dass**
a. ein Lichtweg (2) für das zu detektierende Licht (2) festgelegt ist, der durch das weitere Kühlbauteil (11) hindurch verläuft und/oder dass
b. das weitere Kühlbauteil (11) als wärmeleitendes, elektrisch isolierendes Zwischenelement (12) ausgebildet ist und/oder dass
c. das weitere Kühlbauteil (11) in unmittelbarem Kontakt zu einem Lichtsensor (6) des Detektors (5), insbesondere einer Photokathode (8), und/oder in unmittelbaren Kontakt zu einem einen Lichtsensor (6), insbesondere eine Photokathode (8), tragenden Substrat (7) steht.

5. Scanmikroskop nach einem der Ansprüche 1 bis 4, **dadurch gekennzeichnet, dass**
a. das Kühlbauteil (11) und/oder das weitere Kühlbauteil (13) als aktives Kühlbauteil, insbesondere als Peltier-Element (14) oder als Wärmepumpe oder als Heat-Pipe, ausgebildet ist und/oder dass
b. das Kühlbauteil (11) und/oder das weitere Kühlbauteil (13) derart angeordnet ist, dass die Abwärme des Kühlbauteils (11) und/oder des weiteren Kühlbauteils (13) wenigstens ein Eintrittsfenster des Gehäuses (4) und/oder eine Eintrittsoptik (9) des Gehäuses (4) erwärmt.

6. Scanmikroskop nach einem der Ansprüche 1 bis 5, **dadurch gekennzeichnet, dass** das Kühlbauteil (11) und/oder das weitere Kühlbauteil (13) als passives Kühlbauteil ausgebildet ist, durch das hindurch ein Wärmestrom stattfindet.

7. Scanmikroskop nach Anspruch 6, **dadurch gekennzeichnet, dass**
a. das das Kühlbauteil (11) und/oder das weitere Kühlbauteil (13) zumindest teilweise aus einem elektrisch isolierenden und thermisch leitenden Material, insbesondere aus Bornitrid, Aluminiumnitrid, Aluminiumoxid, Diamant, synthetischem Diamant oder einer Kombination aus diesen Materialien, besteht und/oder dass
b. das Kühlbauteil (11) und/oder das weitere Kühlbauteil (13) sowohl ein elektrischer Isolator, also auch ein thermischer Leiter ist und/oder dass
c. das Kühlbauteil (11) und/oder das weitere Kühlbauteil (13) zumindest teilweise aus einem Kompositmaterial besteht und/oder dass
d. das Kühlbauteil (11) und/oder das weitere Kühlbauteil (13) einen Kern aus einem thermisch leitendem Material, insbesondere aus Aluminium, aufweist, der wenigstens teilweise von einem elektrischen Isolator, insbesondere einer elektrischen Isolatorfolie, beispielsweise einer Kunststofffolie, umgeben ist und/oder dass
e. das Kühlbauteil (11) und/oder das weitere Kühlbauteil (13) einen Kern aus einem thermisch leitendem Material, insbesondere aus Aluminium, aufweist, der wenigstens teilweise von einem elektrischen Isolator umgeben ist, der bezogen auf die Wärmeleitungsrichtung dünner ist, als der Kern.

8. Scanmikroskop nach einem der Ansprüche 1 bis 7, **dadurch gekennzeichnet, dass**
a. das das Kühlbauteil (11) und/oder das weitere Kühlbauteil (13) eine Wärmeleitfähigkeit größer 1 W/mK, insbesondere größer 10 W/mK, insb. größer als 100 W/mK, insbesondere größer 500 W/mK aufweist und/oder dass
b. das Kühlbauteil (11) und/oder das weitere Kühlbauteil (13) eine elektrische Leitfähigkeit kleiner als 10⁻⁷ S/m, insbesondere kleiner als 10⁻⁸ S/m, aufweist.

9. Scanmikroskop nach einem der Ansprüche 1 bis 8, **dadurch gekennzeichnet, dass** das Kühlbauteil (11) und/oder das weitere Kühlbauteil (13) zur Erhöhung der Kriechstromfestigkeit an einer Außenfläche einen mittels eines Labyrinths und/oder mittels Rippen und/oder mittels wenigstens einer Nut und/oder mittels wenigstens einem Vorsprung verlängerten Kriechweg aufweist.

10. Scanmikroskop nach einem der Ansprüche 1 bis 9, **dadurch gekennzeichnet, dass** das Kühlbauteil (11) und/oder das weitere Kühlbauteil (13) im Wesentlichen ringförmig oder zylinderförmig ausgebildet ist.

11. Scanmikroskop nach einem der Ansprüche 1 bis 10, **dadurch gekennzeichnet, dass**
a. dass Zwischenräume des Kühlbauteils (11) und/oder des weiteren Kühlbauteils (13) mit einem elektrisch isolierenden Material gefüllt sind und/oder dass
b. dass Zwischenräume des Kühlbauteils (11) und/oder des weiteren Kühlbauteils (13) mit einem elektrisch und thermisch isolierenden Material gefüllt sind und/oder dass
c. das Kühlbauteil (11) und/oder das weitere Kühlbauteil (13) als thermoelektrischer Wandler, insbesondere als Peltierelement ausgebildet sind, dessen Zwischenräume mit einem elektrisch isolierenden Material gefüllt sind und/oder dass
d. das Kühlbauteil (11) und/oder das weitere Kühlbauteil (13) als thermoelektrischer Wandler, insbesondere als Peltierelement ausgebildet sind, dessen Zwischenräume mit einem elektrisch und thermisch isolierenden Material gefüllt sind und/oder dass
e. das Kühlbauteil (11) und/oder das weitere Kühlbauteil (13) als thermoelektrischer Wandler, insbesondere als Peltierelement ausgebildet sind, dessen Zwischenräume mit Epoxidharz oder Silikon gefüllt sind.

12. Scanmikroskop nach einem der Ansprüche 2 bis 11, **dadurch gekennzeichnet, dass**
a. zwischen dem Detektor (5) und dem Gehäuse (4) eine elektrische Potentialdifferenz vorliegt und/oder dass
b. zwischen dem Detektor (5) und dem Gehäuse (4) eine elektrische Potentialdifferenz vorliegt von mehr als 1000 V, insbesondere von mehr als 2000 V, insbesondere von mehr als 4000 V, insbesondere von mehr als 6000 V, insbesondere von 8000 V vorliegt.

13. Scanmikroskop nach einem der Ansprüche 1 bis 12, **dadurch gekennzeichnet, dass**
a. der Lichtsensor (6) wenigstens eine Photokathode (8) aufweist und/oder dass
b. der Lichtsensor (6) oder ein den Lichtsensor aufweisender Detektor (5) wenigstens eine Photodiode (8), insbesondere eine Lawinendiode, aufweist und/oder dass
c. dem Lichtsensor (6) ein Elektronenbeschleuniger nachgeschaltet ist und/oder dass
d. die Detektorvorrichtung einen den Lichtsensor (6) aufweisenden Detektor (5) beinhaltet, der mit einer Spannung von mehr als 1000 V, insbesondere von mehr als 2000 V, insbesondere von mehr als 4000 V, insbesondere von mehr als 6000 V, insbesondere von 8000 V betrieben ist.

14. Scanmikroskop nach einem der Ansprüche 2 bis 13, **dadurch gekennzeichnet, dass**
a. der Lichtsensor (6) und das Gehäuse (4) mittels des Kühlbauteils (11) und/oder des weiteren Kühlbauteils (13) wärmeleitend verbunden sind, wobei die Kontaktfläche des Kühlbauteils (11) und/oder des weiteren Kühlbauteils (13) mit dem Lichtsensor (6) kleiner ist, als die Kontaktfläche des Kühlbauteils (11) und/oder des weiteren Kühlbauteils (13) mit dem Gehäuse (4) und/oder dass
b. das Kühlbauteil (11) ein passives Kühlbauteil ist, das Wärme von dem Lichtsensor (6) und/oder von dem Substrat des Lichtsensors (6) zu einem weiteren, aktiven Kühlbauteil (14) leitet, das nicht mit dem Lichtsensor (6) und nicht mit einem Substrat des Lichtsensors (6) in unmittelbarem Kontakt steht, und dass das weitere, aktive Kühlbauteil Wärme an das Gehäuse abgibt.

## Claims

1. Scanning microscope, having a detector apparatus (1), which is configured to receive light (2) and to generate electrical signals, with a light sensor (6) having a light incidence side and with a cooling component, wherein the cooling component is in immediate contact with the light sensor and/or with a substrate (7) carrying the light sensor (6) on the light incidence side of the light sensor (6), wherein the detector apparatus has an avalanche diode (10) with an electron accelerator connected upstream thereof.

2. Scanning microscope according to Claim 1, **characterized in that**
a. the detector apparatus has a housing (4) and/or **in that** the light sensor (6) and the cooling component (11) are arranged in a housing (4) and/or **in that**
b. a light path (2) for the light (2) to be detected is defined and passes through the cooling component (11) and/or **in that**
c. the cooling component (11) is embodied in the form of a heat-conducting, electrically insulating intermediate element (12) and/or **in that**
d. the detector apparatus has a housing (4) and **in that** the housing (4) is gas-tight and/or **in that** a vacuum prevails in the housing (4).

3. Scanning microscope according to Claim 1 or 2, **characterized in that** a further cooling component (13) is provided, in particular within the housing (4), and/or **in that** a further cooling component (13) which is in heat-conducting contact with the cooling component (11) is provided and/or **in that** a further cooling component (13) is provided, wherein the cooling component (11) and the further cooling component (13) are thermally connected in series.

4. Detector apparatus (1) according to Claim 3, **characterized in that**
a. a light path (2) for the light (2) to be detected is defined and passes through the further cooling component (11) and/or **in that**
b. the further cooling component (11) is embodied in the form of a heat-conducting, electrically insulating intermediate element (12) and/or **in that**
c. the further cooling component (11) is in immediate contact with a light sensor (6) of the detector (5), in particular with a photo cathode (8), and/or is in immediate contact with a substrate (7) carrying a light sensor (6), in particular a photo cathode (8).

5. Scanning microscope according to one of Claims 1 to 4, **characterized in that**
a. the cooling component (11) and/or the further cooling component (13) is embodied in the form of an active cooling component, in particular a Peltier element (14) or a heat pump or a heat pipe, and/or **in that**
b. the cooling component (11) and/or the further cooling component (13) is arranged such that the waste heat of the cooling component (11) and/or of the further cooling component (13) heats at least one entrance window of the housing (4) and/or an entrance optical unit (9) of the housing (4).

6. Scanning microscope according to one of Claims 1 to 5, **characterized in that** the cooling component (11) and/or the further cooling component (13) is embodied in the form of a passive cooling component, through which heat flows.

7. Scanning microscope according to Claim 6, **characterized in that**
a. the cooling component (11) and/or the further cooling component (13) consists at least partially of an electrically insulating and thermally conducting material, in particular of boron nitride, aluminium nitride, aluminium oxide, diamond, synthetic diamond or a combination of these materials, and/or **in that**
b. the cooling component (11) and/or the further cooling component (13) is both an electric insulator and a thermal conductor and/or **in that**
c. the cooling component (11) and/or the further cooling component (13) at least partially consists of a composite material and/or **in that**
d. the cooling component (11) and/or the further cooling component (13) has a core made from a thermally conducting material, in particular aluminium, which is at least partially surrounded by an electric insulator, in particular an electric insulator film, for example a plastic film, and/or **in that**
e. the cooling component (11) and/or the further cooling component (13) has a core made from a thermally conducting material, in particular aluminium, which is at least partially surrounded by an electric insulator, which is thinner with reference to the heat conduction direction than the core.

8. Scanning microscope according to one of Claims 1 to 7, **characterized in that**
a. the cooling component (11) and/or the further cooling component (13) has a thermal conductivity of greater than 1 W/mK, in particular greater than 10 W/mK, in particular greater than 100 W/mK, in particular greater than 500 W/mK, and/or **in that**
b. the cooling component (11) and/or the further cooling component (13) has an electric conductivity of less than 10⁻⁷ S/m, in particular less than 10⁻⁸ S/m.

9. Scanning microscope according to one of Claims 1 to 8, **characterized in that** the cooling component (11) and/or the further cooling component (13) exhibits tracking that is extended by a labyrinth and/or by ribs and/or by at least one groove and/or by at least one projection on an outer surface in order to increase the tracking resistance.

10. Scanning microscope according to one of Claims 1 to 9, **characterized in that** the cooling component (11) and/or the further cooling component (13) is embodied to be substantially ring-shaped or cylindrical.

11. Scanning microscope according to one of Claims 1 to 10, **characterized in that**
a. intermediate spaces of the cooling component (11) and/or of the further cooling component (13) are filled with an electrically insulating material and/or **in that**
b. intermediate spaces of the cooling component (11) and/or of the further cooling component (13) are filled with an electrically and thermally insulating material and/or **in that**
c. the cooling component (11) and/or the further cooling component (13) are embodied in the form of a thermoelectric transducer, in particular a Peltier element, the intermediate spaces of which are filled with an electrically insulating material, and/or **in that**
d. the cooling component (11) and/or the further cooling component (13) are embodied in the form of a thermoelectric transducer, in particular a Peltier element, the intermediate spaces of which are filled with an electrically and thermally insulating material, and/or **in that**
e. the cooling component (11) and/or the further cooling component (13) are embodied in the form of a thermoelectric transducer, in particular a Peltier element, the intermediate spaces of which with are filled with epoxy resin or silicone.

12. Scanning microscope according to one of Claims 2 to 11, **characterized in that**
a. an electric potential difference is present between the detector (5) and the housing (4) and/or **in that**
b. an electric potential difference of more than 1000 V, in particular of more than 2000 V, in particular of more than 4000 V, in particular of more than 6000 V, in particular of 8000 V, is present between the detector (5) and the housing (4).

13. Scanning microscope according to one of Claims 1 to 12, **characterized in that**
a. the light sensor (6) has at least one photo cathode (8) and/or **in that**
b. the light sensor (6) or a detector (5) having the light sensor has at least one photodiode (8), in particular an avalanche diode, and/or **in that**
c. an electron accelerator is connected downstream of the light sensor (6) and/or **in that**
d. the detector apparatus includes a detector (5) having the light sensor (6), which detector (5) is operated at a voltage of more than 1000 V, in particular of more than 2000 V, in particular of more than 4000 V, in particular of more than 6000 V, in particular of 8000 V.

14. Scanning microscope according to one of Claims 2 to 13, **characterized in that**
a. the light sensor (6) and the housing (4) are thermally conductively connected by way of the cooling component (11) and/or the further cooling component (13), wherein the contact surface of the cooling component (11) and/or of the further cooling component (13) with the light sensor (6) is smaller than the contact surface of the cooling component (11) and/or of the further cooling component (13) with the housing (4) and/or **in that**
b. the cooling component (11) is a passive cooling component which conducts heat from the light sensor (6) and/or from the substrate of the light sensor (6) to a further, active cooling component (14), which is not in immediate contact with the light sensor (6) or with a substrate of the light sensor (6), and **in that** the further, active cooling component gives off heat to the housing.

## Revendications

1. Microscope à balayage possédant un dispositif détecteur (1), lequel est configuré pour recevoir de la lumière (2) et pour générer des signaux électriques, comprenant un capteur de lumière (6), lequel présente un côté d'incidence de la lumière, et comprenant un élément structural de refroidissement, l'élément structural de refroidissement sur le côté d'incidence de la lumière du capteur de lumière (6) se trouvant en contact direct avec le capteur de lumière et/ou avec un substrat (7) qui porte le capteur de lumière (6), le dispositif détecteur possédant une diode à avalanche (10) avec un accélérateur d'électrons monté en amont.

2. Microscope à balayage selon la revendication 1, **caractérisé en ce que**
a. le dispositif détecteur possède un boîtier (4) et/ou **en ce que** le capteur de lumière (6) et l'élément structural de refroidissement (11) sont disposés dans un boîtier (4) et/ou **en ce que**
b. un trajet de lumière (2) est fixé pour la lumière (2) à détecter, lequel suit un tracé à travers l'élément structural de refroidissement (11) et/ou **en ce que**
c. l'élément structural de refroidissement (11) est réalisé sous la forme d'un élément intermédiaire (12) thermoconducteur électriquement isolant et/ou **en ce que**
d. le dispositif détecteur possède un boîtier (4) et **en ce que** le boîtier (4) est hermétique aux gaz et/ou **en ce que** le boîtier (4) est sous vide.

3. Microscope à balayage selon la revendication 1 ou 2, **caractérisé en ce que**, notamment à l'intérieur du boîtier (4), un élément structural de refroidissement supplémentaire (13) est présent et/ou **en ce qu'**un élément structural de refroidissement supplémentaire (13) est présent, lequel se trouve en contact thermoconducteur avec l'élément structural de refroidissement (11) et/ou **en ce qu'**un élément structural de refroidissement supplémentaire (13) est présent, l'élément structural de refroidissement (11) et l'élément structural de refroidissement supplémentaire (13) étant montés thermiquement en série.

4. Dispositif détecteur (1) selon la revendication 3, **caractérisé en ce que**
a. un trajet de lumière (2) est fixé pour la lumière (2) à détecter, lequel suit un tracé à travers l'élément structural de refroidissement supplémentaire (11) et/ou **en ce que**
b. l'élément structural de refroidissement supplémentaire (11) est réalisé sous la forme d'un élément intermédiaire (12) thermoconducteur électriquement isolant et/ou **en ce que**
c. l'élément structural de refroidissement supplémentaire (11) se trouve en contact direct avec un capteur de lumière (6) du détecteur (5), notamment une photocathode (8), et/ou en contact direct avec un substrat (7) qui porte un capteur de lumière (6), notamment une photocathode (8).

5. Microscope à balayage selon l'une des revendications 1 à 4, **caractérisé en ce que**
a. l'élément structural de refroidissement (11) et/ou l'élément structural de refroidissement (13) supplémentaire (11) est réalisé sous la forme d'un élément structural de refroidissement actif, notamment sous la forme d'un élément de Peltier (14) ou sous la forme d'une pompe à chaleur ou sous la forme d'un caloduc et/ou **en ce que**
b. l'élément structural de refroidissement (11) et/ou l'élément structural de refroidissement supplémentaire (13) est disposé de telle sorte que la chaleur dissipée de l'élément structural de refroidissement (11) et/ou de l'élément structural de refroidissement supplémentaire (13) réchauffe au moins une fenêtre d'entrée du boîtier (4) et/ou une optique d'entrée (9) du boîtier (4).

6. Microscope à balayage selon l'une des revendications 1 à 5, **caractérisé en ce que** l'élément structural de refroidissement (11) et/ou l'élément structural de refroidissement supplémentaire (13) est réalisé sous la forme d'un élément structural de refroidissement passif à travers lequel se produit un flux de chaleur.

7. Microscope à balayage selon la revendication 6, **caractérisé en ce que**
a. l'élément structural de refroidissement (11) et/ou l'élément structural de refroidissement supplémentaire (13) se compose au moins partiellement d'un matériau électriquement isolant et thermoconducteur, notamment de nitrure de bore, de nitrure d'aluminium, d'oxyde d'aluminium, de diamant, de diamant synthétique ou d'une combinaison de ces matériaux, et/ou **en ce que**
b. l'élément structural de refroidissement (11) et/ou l'élément structural de refroidissement supplémentaire (13) est à la fois un isolateur électrique et un conducteur thermique et/ou **en ce que**
c. l'élément structural de refroidissement (11) et/ou l'élément structural de refroidissement supplémentaire (13) se compose au moins partiellement d'un matériau composite et/ou **en ce que**
d. l'élément structural de refroidissement (11) et/ou l'élément structural de refroidissement supplémentaire (13) possède un noyau en un matériau thermoconducteur, notamment en aluminium, lequel est au moins partiellement entouré par un isolateur électrique, notamment un fil isolant électrique, par exemple un film de matière plastique, et/ou **en ce que**
e. l'élément structural de refroidissement (11) et/ou l'élément structural de refroidissement supplémentaire (13) possède un noyau en un matériau thermoconducteur, notamment en aluminium, lequel est au moins partiellement entouré par un isolateur électrique qui, en référence au sens de conduction de la chaleur, est plus mince que le noyau.

8. Microscope à balayage selon l'une des revendications 1 à 7, **caractérisé en ce que**
a. l'élément structural de refroidissement (11) et/ou l'élément structural de refroidissement supplémentaire (13) présente une conductivité thermique supérieure à 1 W/mK, notamment supérieure à 10 W/mK, notamment supérieure à 100 W/mK, notamment supérieure à 500 W/mK et/ou **en ce que**
b. l'élément structural de refroidissement (11) et/ou l'élément structural de refroidissement supplémentaire (13) présente une conductivité électrique inférieure à 10⁻⁷ S/m, notamment inférieure à 10⁻⁸ S/m.

9. Microscope à balayage selon l'une des revendications 1 à 8, **caractérisé en ce que** l'élément structural de refroidissement (11) et/ou l'élément structural de refroidissement supplémentaire (13), en vue d'accroître la résistance aux courants de fuite, possède sur une surface extérieure un chemin de fuite prolongé au moyen d'un labyrinthe et/ou au moyen de nervures et/ou au moyen d'au moins une rainure et/ou au moyen d'au moins une partie saillante.

10. Microscope à balayage selon l'une des revendications 1 à 9, **caractérisé en ce que** l'élément structural de refroidissement (11) et/ou l'élément structural de refroidissement supplémentaire (13) est de configuration sensiblement annulaire ou cylindrique.

11. Microscope à balayage selon l'une des revendications 1 à 10, **caractérisé en ce que**
a. les espaces intermédiaires de l'élément structural de refroidissement (11) et/ou de l'élément structural de refroidissement supplémentaire (13) sont remplis d'un matériau électriquement isolant et/ou **en ce que**
b. les espaces intermédiaires de l'élément structural de refroidissement (11) et/ou de l'élément structural de refroidissement supplémentaire (13) sont remplis d'un matériau électriquement et thermiquement isolant et/ou **en ce que**
c. l'élément structural de refroidissement (11) et/ou l'élément structural de refroidissement supplémentaire (13) sont réalisés sous la forme de convertisseurs thermoélectriques, notamment sous la forme d'un élément de Peltier, dont les espaces intermédiaires sont remplis d'un matériau électriquement isolant et/ou **en ce que**
d. l'élément structural de refroidissement (11) et/ou l'élément structural de refroidissement supplémentaire (13) sont réalisés sous la forme de convertisseurs thermoélectriques, notamment sous la forme d'un élément de Peltier, dont les espaces intermédiaires sont remplis d'un matériau électriquement et thermiquement isolant et/ou **en ce que**
e. l'élément structural de refroidissement (11) et/ou l'élément structural de refroidissement supplémentaire (13) sont réalisés sous la forme de convertisseurs thermoélectriques, notamment sous la forme d'un élément de Peltier, dont les espaces intermédiaires avec de la résine époxy ou du silicone.

12. Microscope à balayage selon l'une des revendications 2 à 11, **caractérisé en ce que**
a. une différence de potentiels électrique est présente entre le détecteur (5) et le boîtier (4) et/ou **en ce que**
b. une différence de potentiels électrique supérieure à 1000 V, notamment supérieure à 2000 V, notamment supérieure à 4000 V, notamment supérieure à 6000 V, notamment égale à 8000 V, est présente entre le détecteur (5) et le boîtier (4).

13. Microscope à balayage selon l'une des revendications 1 à 12, **caractérisé en ce que**
a. le capteur de lumière (6) possède au moins une photocathode (8) et/ou **en ce que**
b. le capteur de lumière (6) ou un détecteur (5) qui possède le capteur de lumière possède une photodiode (8), notamment une diode à avalanche et/ou **en ce que**
c. un accélérateur d'électrons est monté en aval du capteur de lumière (6) et/ou **en ce que**
d. le dispositif détecteur contient un détecteur (5) qui possède le capteur de lumière (6), lequel fonctionne à une tension supérieure à 1000 V, notamment supérieure à 2000 V, notamment supérieure à 4000 V, notamment supérieure à 6000 V, notamment égale à 8000 V.

14. Microscope à balayage selon l'une des revendications 2 à 13, **caractérisé en ce que**
a. le capteur de lumière (6) et le boîtier (4) sont reliés de manière thermoconductrice au moyen de l'élément structural de refroidissement (11) et/ou de l'élément structural de refroidissement supplémentaire (13), la surface de contact de l'élément structural de refroidissement (11) et/ou de l'élément structural de refroidissement supplémentaire (13) avec le capteur de lumière (6) étant plus petite que la surface de contact de l'élément structural de refroidissement (11) et/ou de l'élément structural de refroidissement supplémentaire (13) avec le boîtier (4) et/ou **en ce que**
b. l'élément structural de refroidissement (11) est un élément structural de refroidissement passif qui mène la chaleur du capteur de lumière (6) et/ou du substrat du capteur de lumière (6) à un élément structural de refroidissement supplémentaire actif (14), qui ne se trouve pas en contact direct avec le capteur de lumière (6) et un substrat du capteur de lumière (6), et **en ce que** l'élément structural de refroidissement supplémentaire actif délivre la chaleur au boîtier.
